(19) Europäisches Patentamt
European Patent Office
Office européen des brevets

(11) Publication number: 0 259 704 A2

# (12) EUROPEAN PATENT APPLICATION

(21) Application number: 87112427.7

(51) Int. Cl.4: G06F 15/60

(22) Date of filing: 26.08.87

(30) Priority: 12.09.86 US 907516

(43) Date of publication of application: 16.03.88 Bulletin 88/11

(84) Designated Contracting States: AT BE CH DE ES FR GB GR IT LI LU NL SE

(71) Applicant: DIGITAL EQUIPMENT CORPORATION
146 Main Street
Maynard, MA 01754(US)

(72) Inventor: Hooper, Donald F.
13 Thoreau Road
Northboro Massachusetts 01532(US)
Inventor: Kundu, Snehamay
84 Bergeron Road
Marlboro Massachusetts 01752(US)

(74) Representative: Patentanwälte Grünecker, Kinkeldey, Stockmair & Partner
Maximilianstrasse 58
D-8000 München 22(DE)

## (54) Bitwise implementation mechanism for a circuit design synthesis procedure.

(57) In a procedure for synthesizing circuit designs, a SYNTHESIZE command in a consequence portion of a rule can be used to control the creation of bit-level instances from a description of a more abstract instance whose interface consists of multi-bit signals. The synthesize command has a form that identifies multibit signal/part objects in the data base relative to the current multi-bit instance, which are then synthesized over the range of most-significant to least significant bit. A collection of rules, called macrorules are enclosed with in a 'synthesize' command. An iteration controlled by "current bit," ranging from least significant to most significant bit, ensues. At each step of the iteration, all macrorules are tested and applied if they are 'true'. The macrorules can query whether the current bit is a function of the least or most significant bits. The macrorules can also establish connectivity to any signal bit relative to the current, the least significant or the most significant bit. Signals which represent numeric constants, are converted to the correct binary value for each bit of the bitwise synthesis. During this process, new signal names with bit subscripts are generated, if needed, and a connections are in made so that the resulting data base represents an electrically connected circuit.

FIG. 4.

RULE
40
NAME
41
COMMENTS
*
42
ANTECEDENT
43
CONSEQUENCE
44
VERSION
45
HISTORY
46
SIZEWIN
47

EP 0 259 704 A2

# BITWISE IMPLEMENTATION MECHANISM FOR A CIRCUIT DESIGN SYNTHESIS PROCEDURE

## BACKGROUND OF THE INVENTION

### 1. Field of the Invention

This invention relates generally to the synthesis of circuit designs and, more particularly, to the replacement of circuit components having a high level (abstract) representation with the more fundamental binary bit level representation.

### 2. Description of the Related Art

In the usual circuit design synthesis procedures, simple instance replication is used to produce a number of copies of a abstract multibit instance (or data base object) in which the pins of each copy are assigned a bit position of a multibit vector. Similarly, a simple loop procedure can produce copies of a data base object to effectively instantiate or replicate a multibit entity at the bit level. Such loop procedures to not have the flexibility to synthesize any but standard circuit entities.

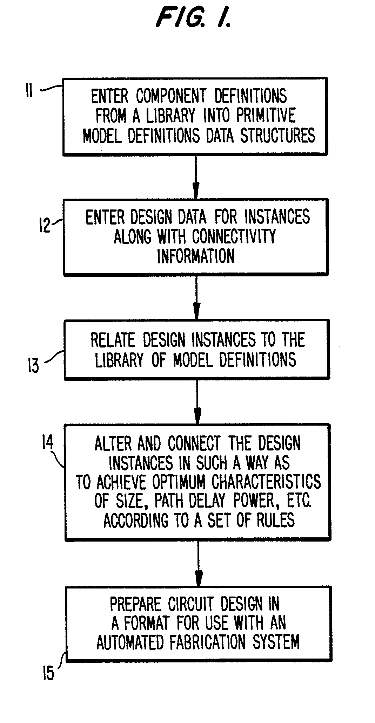

Referring next to Fig. 1, the procedure for synthesizing a logic circuit design according to the prior art is shown. Model definition data structures from a library of component definitions is entered into the data structures associated with the synthesis data base in step 11. In step 12, the information related to the instances of the circuit design including the connectivity information is entered in the data base. The instances of the circuit design are generally in a behavioral or functional form when entered in the synthesis data base. The synthesis data base relates the instances of the circuit design to the model instances in step 13. In step 14, a set of rules for the synthesis procedure is applied to each of the model instances and the model instances are altered and connected in such a way as to maximize certain parameters such as size, path delay, power, etc. In step 15, the resulting circuit design is placed in a format that can control the automated fabrication of the circuit.

## FEATURES OF THE INVENTION

It is an object of the present invention to provide an improved design circuit synthesis procedure.

It is a feature of the present invention to provide an improved technique for replacing high level representation of circuit components in a circuit design with bit level representations of the components.

It is yet another feature of the present invention to provide an iterative procedure for replacing complex data base objects with a plurality of bit level data base objects.

## SUMMARY OF THE INVENTION

The aforementioned and other features are obtained, according to the present invention, by providing a procedure for creating bit-level model instances for replacing of higher level multi-bit model instances. The procedure includes a format in the consequence portion of a rule that permits flexibility in the creation of the bit-level model instances. The bit-level model instances can be a function of the least significant, most significant or current bit. The high level (abstract) model instances can have multibit port with unequal input and output signal ranges.

These and other features of the present invention will be understood upon reading of the following description along with the drawings.

## BRIEF DESCRIPTION OF THE DRAWINGS

Figure 1 is a flow diagram illustrating a procedure for synthesizing circuit designs according to the related art.

Figure 2 is a flow diagram illustrating a procedure for synthesizing circuit designs with which the present invention is intended to be used.

Figure 3 is an overall diagram of the architecture for data structures of logic design and logic synthesis rules.

Figure 4 is an illustration of the structure of a rule filing according to the present invention.

Figure 5 illustrates the forms of the antecedent portion of the rule file according to the present invention.

Figure 6 illustrates the forms of the consequence portion of the rule file according to the present invention.

Figure 7 is diagram showing the replication of a multibit model instance according to the present invention.

Figure 8 is a diagram illustrating the action of two rules on separate multibit instances according to the present invention.

Figure 9 is a diagram illustrating the synthesis of an 'EQL' operator.

Figure 10 is a diagram illustrating the synthesis of an instance where the multibit ports have unequal bit-ranges.

## DESCRIPTION OF THE PREFERRED EMBODIMENT

### 1. Detailed Description of the Figures

Figure 1 has been previously described in relationship to the related art.

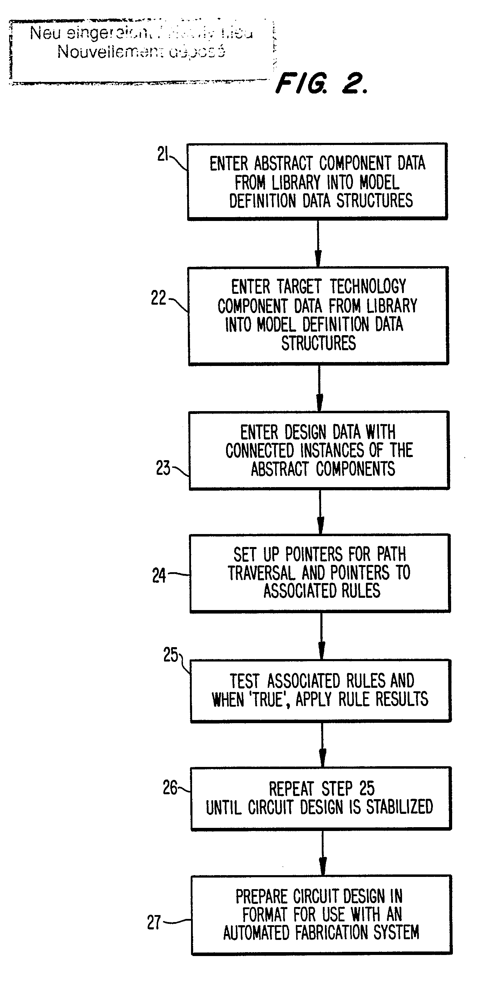

Referring next to Figure 2, the synthesis procedure of the present invention is shown. In step 21, abstract component data from a library of such data is entered into model definition data structures of the synthesis procedure. In step 22, component data relating to the target technology from the library is entered into model definition data structures of the synthesis procedure. The circuit design data, with the connected instances described in terms of abstract components, is entered into the synthesis procedure in step 23. In step 24, the synthesis procedure provides two sets of points. The first set of pointers permits the synthesis procedure to follow any arbitrary path through the design circuit. The second set of pointers couples rules with associated data base structures. In step 25, the associated rules are tested for each instance and when the test provides a 'true' result, the consequences of the rule is implemented. In the preferred embodiment, each rule has an antecedent portion and a consequence portion. The antecedent portion includes a test algorithm, and the consequence portion provides the information required to implement a result of the test. Because the rules are applied to instances in a sequential manner, and because in the preferred embodiment the test procedures can involve neighboring instances that were changed as a result of a test applied to that instance, the process is repeated until the circuit design has stabilized. In step 27, the final version of the circuit design is placed in a format suitable for use in an automated circuit fabrication system.

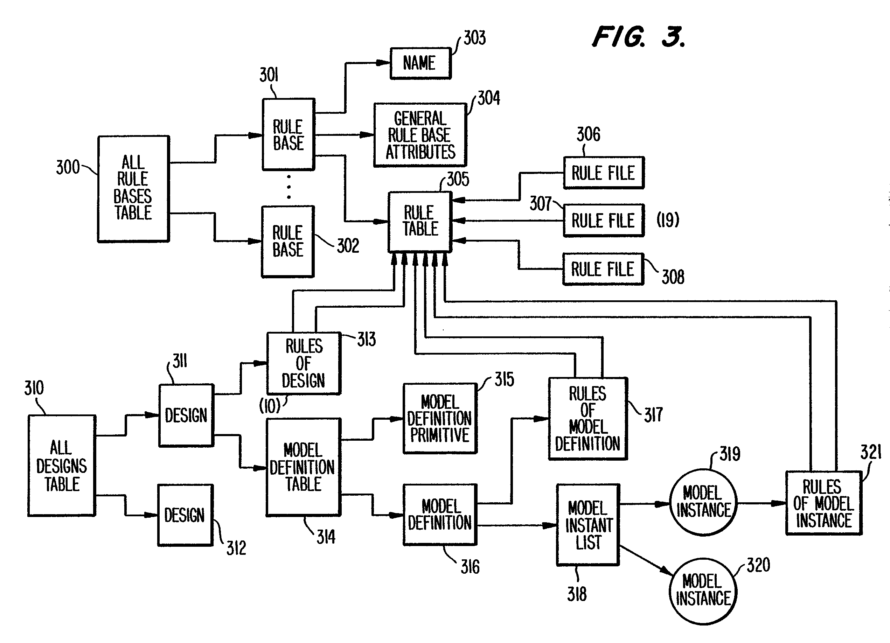

Referring now to Fig. 3, the architectural organization for the storage of the logic synthesis rules and the logic design rules are shown. Two storage hierarchies are available, one representing rule information and the second representing digital design information. These information hierarchies interact when pointers are established, relating the design objects to specific groups of rules. A rule file 306 through 308 is collection rules arbitrarily organized by the creator of the file. Several rule files can be transferred to a rule table 305. The rule table 305 is a lookup table that is indexed by the name of the rules stored therein. The rule table 305 is an attribute of a rule base 301 that has in addition to the rules stored in rule table 350, a name 303 and other attributes 304 of the rule base 301. Any number of rule bases 301 through 302 are contained in the table of all of the rule bases 300. The all rule bases table 300 is a lookup table indexed by the name of the rule base. The all rule base table 300 is the top of the rule information hierarchy. The logic design data is partitioned into blocks, called model definitions 315 through 316. Any number of model definitions can be stored in the model definition table, 314 a lookup table indexed by the model name. A model definition can contain a model instance list 318 that includes model instances 319 and 320 that are model instances of other model definitions. For any functional part type or structural body of a given name, only one model definition can exist. However, any functional part type or structural body can have 0 or more model instances. The attributes of the model definition are common to all of the instances associated therewith and, therefore need to be stored only with the model definition. The model definition contains "LIBRARY" information. The attributes of the model instances, such as timing parameters and simulation values are unique to each model instance and consequently must be stored with the associated instance. Those model definitions with no model instances or for which a "LIBRARY" attribute is specified are considered primitive model definitions stored in table 315. The model definition table 314 is stored in a design table 312, the design table capable of possessing other attributes. Any number of designs 311 through 312 can be contained in the all designs table 310.

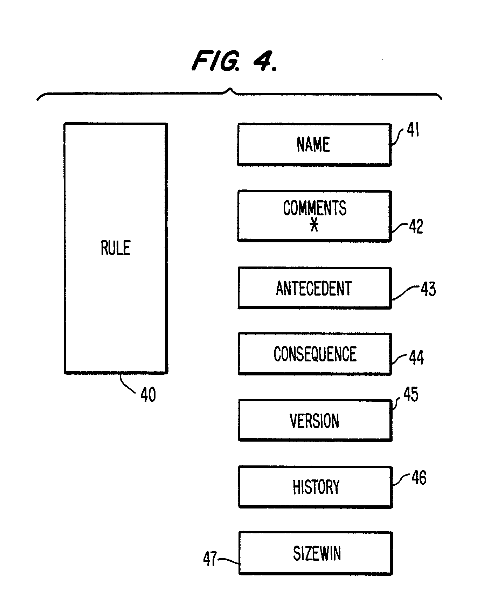

Referring next to Fig. 4, the general structure of the rule 40 used in the logic network synthesis is shown. At rule file read time, the structure is created for each rule 40. A location in the file is reserved for the name field 41 of the rule. Another location is reserved for comments file 42 which are formal comments concerning the use of the rule. Antecedents field 43, consequences field 44, version field 45, history field 46 and size in field 47 are fields within the rule structure. The antecedent field 43 and the consequence field 44 are described below. The verson field 45 includes version information from a host computer aided design (CAD) data management system, when available, or time_of_day and date information, when available. The rule history field 46 is intitially set to zero and is subsequently used to keep a running count of the number of times the associated rule is applied.

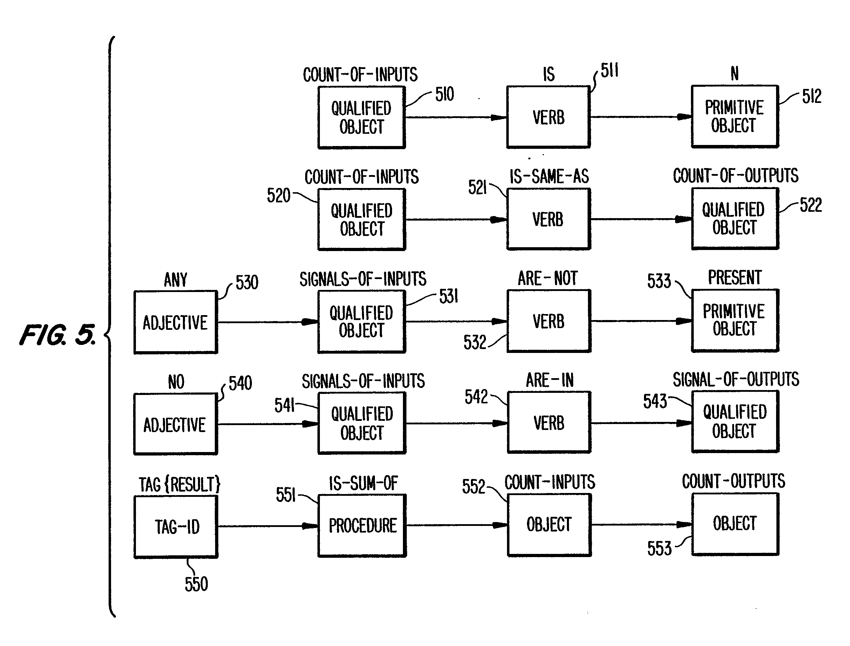

Referring to Fig. 5, five examples of the antecedent field 43 of the rule structure of Fig. 4 are shown. In these examples, a qualified object is database object at the end of an access chain for which the beginning is a current instance. A qualified object may also be a plurality of qualified objects. A primitve is taken as is without further database access (e.g. a number is a primitive object). In the first example, (count_of_inputs is N), the qualified object 510 is followed by a verb 511 followed by a primitive object 512. The meaning of this field is that if the current instance has N inputs, then this antecedent will return a 'true' (T) when evaluated, otherwise, the antecedent will return a 'nil' when evaluated. In the second example, (count_of_inputs is_same_as_count_of_outputs) the qualified object 520 is followed by a verb 521 which in turn is followed by a qualified object 522. In the third example, (any signals_of_inputs are_not present) illustrates an adjective 530 followed by a qualified object 531, in turn followed by a verb 532, which in turn is followed by primitive object 533. This field is interpreted as follows, when any of the inputs of the current instance is not coupled to a signal, the antecedent will return a 'true' value. In example four, (no signals_of_inputs are_in signals_of_outputs), an adjective 540 is followed by a qualified object 541, in turn followed by a verb 542, which is in turn followed by a qualified object 543. In the fifth example, (tag {result} is_sum_of count_inputs count_outputs), a value {result} 550 is stored that is the result of a called procedure 551 which an arbitrary number of arguments 552, 553 et al. This procedure call permits LISP functions to be used by a rule antecedent field. The arguments 552, 553 et al. can be primitive objects or qualified objects. The name {result} can be used during the remainder of the rule antecedent field procedure and consequence field procedures to fetch the value stored under that name. The number of tags is not limited and all tag storage is erased when the antecedents portion of the rule is false or at the completion of the consequences portion of the rule. This type of antecedent always returns a 'true' (T) value, regardless of the value of the tag field. In the preferred embodiment, it is possible to use keywords (tag1, tag2, etc.) and to refer to them directly as in the expressions:

(tag {result} is_sum_of count_inputs count_outputs)
( {result} is_less_than N)

which can also be expressed:

(tag1 is_sum_of count_inputs count_outputs)
(tag1 is-less_than N)

Rule antecedents can also be nested by using the boolean term 'AND' or 'OR'. This nesting can be done in the format of the LISP procedures. For examples:

(or (count_ins is_less than N)
( {result} is_less than N)

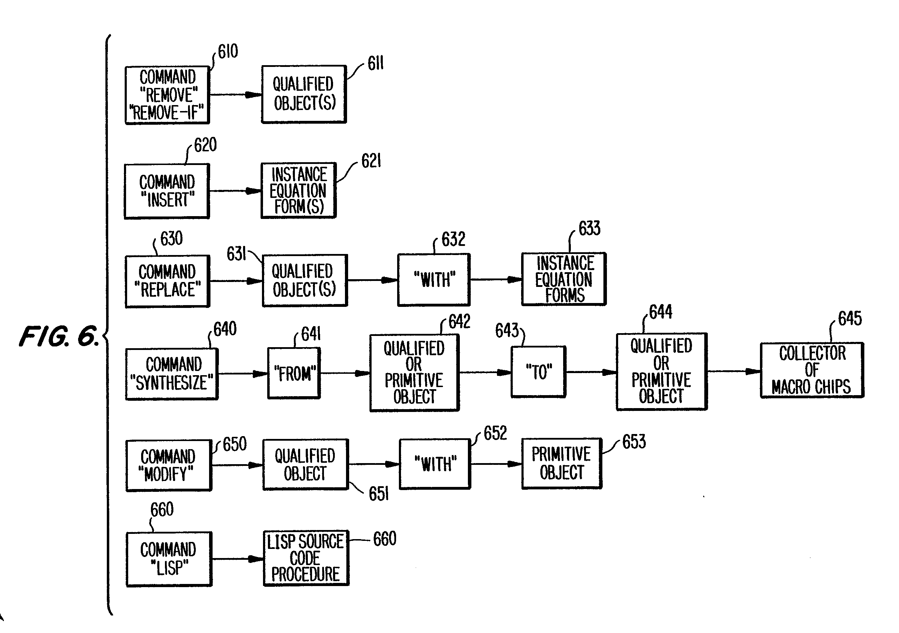

Referring next to Fig. 6, the structure of the consequence field of the rule is illustrated by six examples. In the first example, the command "remove" or "remove_if_no_dests" 610 is used to remove one or more instances 611 from the instances of the current model definition. In the second example of Fig. 6, the "insert" command 620 is used to perform the reverse of the 'remove' command 610. the argument to the 'insert' command is a suitable equation from 621 with optional settings of database attributes to the instances being inserted. The insertion of a model instance is described in detail in the co-pending Patent Application entitled "Rule Structure for Insertion of New Elements in a Circuit Design Synthesis Procedure" identified above. The third example illustrates the 'replace' command 33. This command is combined with the 'remove' and the 'insert' command to remove one or more qualified model instance objects 631 and then to insert one or more model instance objects derived from equation form 633. The fourth example of Fig. 6 illustrates the form of the 'synthesize' command 640. this command is used for complex multibit synthesis in which the current instance operated upon by the rule has the attributes of most significant bit and least significant bit, as is common in high level specifications of digital designs. An example of such a device is a 32 bit incrementer, which can have a most significant bit of 31 and a least significant bit of 0. Following the 'synthesize' command is the keyword 'from' 641, followed by access to the most significant bit 642. The most significant bit 642 is followed the keyword 'to', followed by access to the least significant bit 644 and finally followed by a collection of rules 645. The fifth example of Fig. 6 identifies the form of the 'modify' command 650. This command is used to alter a database object by setting its value. The 'modify' keyword is followed by a qualified object 651, the qualified object being followed by the keyword 'with' 652. The keyword 'with' is then followed by a primitive object 653. The sixth example of Fig. 6 uses the 'LISP' keyword to permit entry of a LISP procedural expression 660. This procedural capability provides additional flexibility to modify the design database.

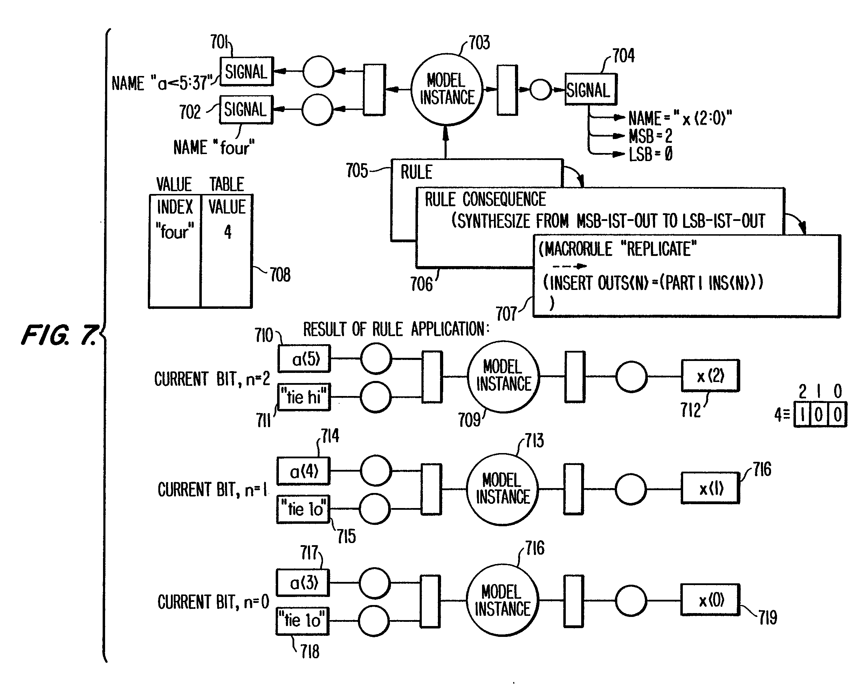

Referring now to Fig. 7, a rule 705 is applied against a model instance 703. The model instance is coupled to an output signal 704 which has a most significant bit (MBS) 2 and a least significant bit (LSB) 0. The model instance is coupled to input signals 701 and 702. Signal 701 has a MSB 5 and a LSB 3. Signal 702 is in the value table 708 and therefore represents a constant 4. the rule consequence (synthesize from MSB-1st-out to LSB-1st-out <macrorule>) is interpreted. the computation MSB of first output minus LSB of first output plus 1 yields three, the number of iterations of the control loop. The current bit 'n' is set of 0 for the first iteration. In each iteration, the macrorule is interpreted to insert the equation outs <n> = (part_1 ins <n>). The first iteration therefore inserts a model instance 716 with an output signal "x" concatenated with the bit calculated by adding 'n' to the LSB 0 of the output 704 of the current model instance 703, therefore producing the signal 719 "x <0>". For the inputs, "a <3> " 717 is produced by concatenating "a" with 'n' plus the LSB of the first input 1. The signal "tie_lo" 718 is produced by taking the binary value 1 of the bit position 'n'=0 of the number 4, corresponding to the value of the second input "four" 702. ("tie-lo") is a signal representing binary constant 0, while "tie-hi" is a signal representing binary constant 1. The second iteration inserts the instance 713 with outputs 716 and inputs 714 and 715. In this iteration, the current bit 'n' is 1. All signals bits relative to the current bit are now 1 higher than they were in the previous iteration. Note that bit 1 of the number 4 still yields "tie_lo". The third and last iteration inserts the instance 709 with outputs 712 and inputs 710 and 711. The current bit has been incremented to 2, and all signals produced have bit significance of the value of the current bit 2 plus their corresponding LSB from the instance 703 signals 1, 2 and 4.

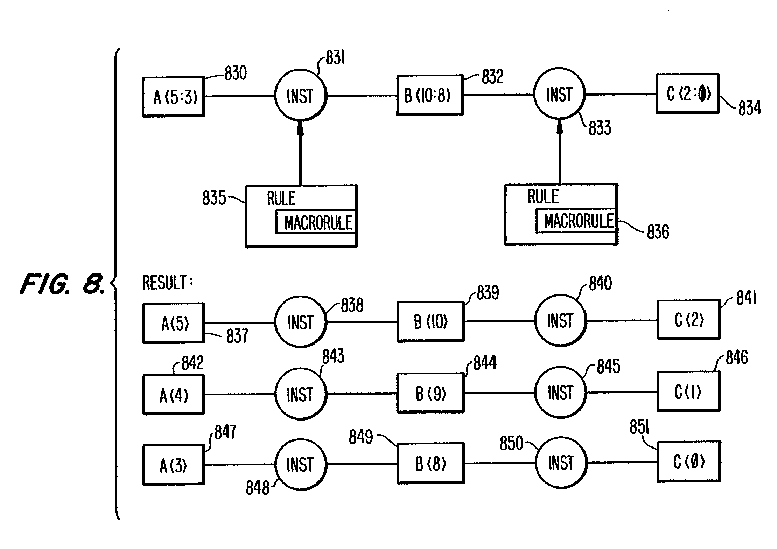

Referring now to Fig. 8, two multibit instances 831 and 833 have signal fields "A <5:3>" 830, "B <10:8>" 832 and "C <2:0>" 834 associated therewith. The rules 835 and 836 are applied against the two instances. The first rule 835 to be applied creates and inserts instances 838, 843 and 848 with outputs to 839, 844 and 849 and inputs from 837, 842 and 847. The signals "B <10>", "B <9>" and "B <8>" did not previously exist and are therefore created. When the second rule 836 is applied, instances 840, 845 and 850 are created and inserted, with outputs to 841, 846 and 851. The input signals 839, 844 and 849 are found to already exist, therefore connection is made to the existing signals as described in U.S. Patent Application entitled "Rule Structure for Insertion of New Elements in a circuit Design Synthesis Procedure."

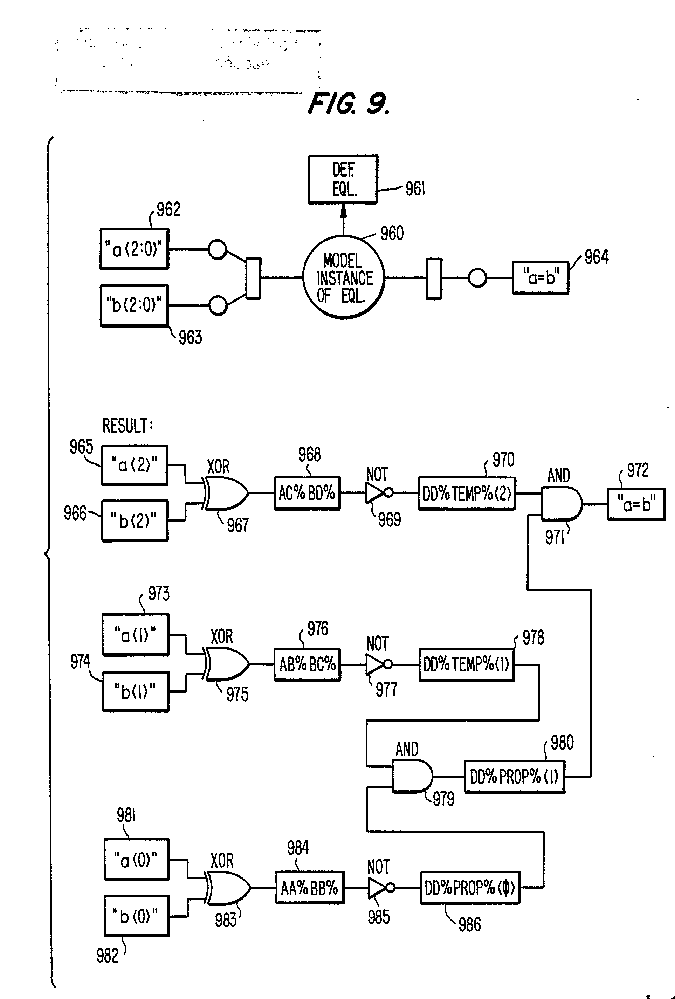

Referring next to Fig. 9, the synthesis of an instance 960 of high level model 'EQL is illustrated. The definition of 'EQL' 961 describes its functionality as the output is true if the binary values of two multibit input signals are equal. The rule to synthesize the instance 960 with output signal 964 and input signals 962 and 963 is as follows:

```
(p "expand eql"
(model is EQL)
(any width-signal-tag-ins is_greater_than 1)
(no names-signal-ins are "O")
→
(synthesize from msb-of 1st-tag to 1sb-of-1st-tag
(macrorule "output of eql"
(<n> is <msb>)
→
(insert
"temp% <n>" = (not (xor "ins <n>))
1st-out = (and "temp% <n> " "prop% <n-1>")
)
)
(macrorule "middle stages of eql"
(<n> is_greater_than <1sb>)
(<n> is_less_than<msb>)
→
(insert
"temp% <n>" = (not (xor "ins <n>))
"prop% <n> = (and "temp% <n>" "prop% <n-1>"
)
)
(macrorule "first stage of eql"
(<n> is <1sb>)
→
(insert "prop% <n>" = (not (xor "ins <n>")))
)
)
(remove "instance")
)
```

This rule, when applied produces bit-level instances and their interconnections as shown in Fig. 9. The 'synthesize' command specifies synthesis across the range of the MSB to LSB of the first input, in this case, causing three iterations. The first macrorule will be applied only if the current bit <n> is equal to the <msb>, as indicated by the macrorules antecedent. The second macrorule is applied only when the current bit <n> lies between the <1sb> and <msb>. The third macrorule will be applied only when the current bit <n> is equal to the <1sb>. The first iteration of the control loop inserts the instances 983 and 985 with connectivity to signals 981, 982, 984 and 986, due to application of the third macrorule when current bit = LSB = 0. The signals "a<0>" 981 and "b<0>" 982 corresponds to the inputs 962 and 963 of the current model instance 960. The signal 984 is unique, derived from the equation nest, therefore having only one source 983 and one destination 985. The signal 986 is also unique, within the scope of the set of macrorules by virtue of the substraing "DD%". The second iteration inserts instances 975, 977 and 979 with connectivity to signal 973, 974, 976, 978 and 980, due to application of the second macrorule. The signal named "prop%<n-1>" produces the identical signal name of "prop%<n> of the previous iteration, therefore causing a connection 986 to the instance 979. The third iteration inserts instances 967, 969 and 971 with connectivity to signals 965, 966, 968, 970 and 972, due to application of the first macrorule when current bit = msb = 2. The propagation of bit equal functionality is again continued by the use of "prop%<n-1>". The connection to the output signal "a=b" of the current model instance is finally established, completing the bit-level synthesis operation.

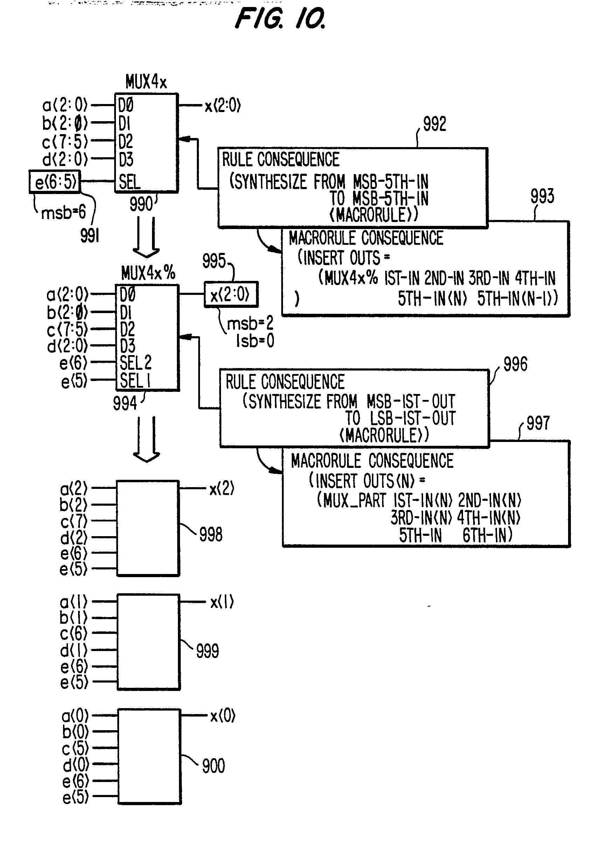

Referring next to Fig. 10, the synthesis of a multi-bit instance in which there are unequal MSB-to-LSB bit ranges is illustrated. A 'SEL' input signal is an connected to a signal 991 with a range of 2 bits, and MSB = 6. Functionally, the 'SEL' chooses one of the four data inputs to be steered to the output, based on its encoding. The four data inputs "a<2:0>", "b<2:0>", "C<7:5>", "d<2:0>" and the data output 'x<2:0>" have a range of 3 bits. A rule consequence with consequence 992 is selected. Only one iteration or the control loop occurs, since the 'FROM' and 'TO' values both refer to the MSB of the fifth input 991. A macrorule 993 creates a new instance 94 with single bit select inputs "e<6>2" and "e<5>". This is accomplished by referring to the current bit through 5th-in <n> of the top instance in Fig. 10 and an offset to the current bit 5th-in<n-1> in the insertion statement of the macrorule 993. Later, the model instances 994 become the current instance, and another rule with consequence 996 is applied. The macrorule consequence 997 results in the insertion of instances 998, 999 and 900. Macrorule 997 selects the inputs "e<6> " and "e<5>" of the "instance" 994 by using the access forms 5th-in and 6th-in. Connection of bit level signals for data inputs a, b, c and d and outputs x is achieved by using the bracket <n> to identify bit position.

## 2. Operation of the Preferred Embodiment

The present invention provides a rule consequence form that permits not only simple instance generation at the bit level, but testing bit significance to selectively control a subset of rules called macrorules, and creation of special case connectivity between different bit positions. The present invention permits a variety of new types of synthesis to occur, involving generation of logic such as testable scan latch systems, comparators, incrementer, decrementers and shift registers.

The 'synthesize' command format is described in U.S. Patent Application entitled "Rule Structure In a Procedure for Synthesis of Logic Circuit Designs". When a rule is applied against a current model instance, the rule consequence in this case contains the statement:

(synthesize from <msb-access> to <1sb-access> <macrorules> )

At rule execution time, <msb-access> and <1sb-access> return numbers when evaluated. These are the most significant bit and the least significant bit of a selectively chosen signal/part associated withthe current instance, respectively. The operation (MSB minus LSB plus 1) produces the number of iterations to occur in the synthesis control loop. The terms 'msb' and '1sb' are local variables which remain constant for the duration of the control loop application. A current bit 'n' acts as a loop control variable and is assigned an initial value of 0, and incremented on each iteration. Each iteration, the full collection of macrorules are tested to find if their individual antecedents return a 'true' verdict. In addition to accessing the data base relative to the current model instance, the macrorules may access the values of the MSB, LSB and current bit, and can compare the relationship between these numbers. For example, a macrorule can check whether the current bit is equal to MSB minus 1, and if so, insert special bit level functionality into the data base. Any macrorule within the scope of a 'parent' rule is eligible for application. There is no arbitration involved to chose a best macrorule. Instead, all macrorules with true verdicts are applied.

The macrorules can insert bit level instances with signal names containing bit position identifiers, called bit subscripts. The subscripts are contained in brackets as a standard of every synthesis system. Again the insertion equations can refer to the 'msb', '1sb' and 'n', and numeric offsets of the same, for the creation of bit significant signal names. A reference to a port instance of the current instance such as 1st-output <n> implies that a signal will be created whose root name (non-bracketed option) is the same as that of the first output of the current model instance, with a bit subscript of current bit plus the least-significant bit of the first output. This flexibility allows complete freedom in the naming of the range of bits for multi-bit instances, and makes it easy to synthesize instances connected to bit fields of very large multi-bit signals.

Signal names which represent numeric constants are maintained in a value table. At signal access time for an equation insertion, the value of the signal name is retrieved from the value table. If the signal is a constant, a number is returned. The bit access, indicating a bit position relative to 'msb', '1sb' or 'n' is evaluated to determine the correct bit position of the constant. The binary value of the bit position in the number determines whether a logical high, "tie-hi" (for 1) or a logical low, "tie-hi", (for 0) is to be corrected.

Following the completion of the control loop, and the insertion of bit level model instances, the 'synthesize' antecedent form is usually followed by the statement (remove *instance*) to remove the current model instance from the data base. Thus transformation of a logic design from a high level representation to a more complex binary level representation is achieved.

The foregoing description is included to illustrate the operation of the preferred embodiment and is not meant to limit the scope of the invention. The scope of the invention is to be limited only by the following claims. From the foregoing description, many variations will be apparent to those skilled in the art that would yet be encompassed by the spirit and scope of the invention.

## Claims

1. In a procedure for synthesizing circuit designs, a method for creation of bit-level instances from higher level instances having at least one multi-bit port comprising the steps of:
providing a control loop over the range of bit signals from a least significant bit to a most significant bit of said multibit port;and
executing at least one macrorule for synthesizing each bit-level instance.

2. The method for creation of bit-level instances of claim 1 further comprising the step of providing keywords to indicate a range of said bit-level synthesis.

3. The method for creation of bit-level instances of claim 2 further comprising the step of defining said macrorule only within said a bit range of a parent rule.

4. The method for creation of bit-level instances of claim 2 further comprising the step of providing a macrorule capable of testing for any displacement of a current value of a control loop variable with respect to said most significant bit and said least significant bit.

5. The method for creation of bit-level instances further comprising the step of reserving at least one character to designate an internally generated signal.

6. In a circuit design synthesis procedure, a rule syntax for synthesizing a data base object comprising: an antecedent portion for determining when a preselected condition is true: and
a consequence portion providing for replacing said data base object with a plurality of bit level data base objects, said consequence portion including at least one rule controlling said synthesis.

7. The rule syntax for data base object synthesis of claim 6 wherein said consequence rule portion further includes fields designating a range for said bit level data base objects.

Neu eingereicht / Newly filed
Nouvellement déposé

FIG. 1.

11
ENTER COMPONENT DEFINITIONS FROM A LIBRARY INTO PRIMITIVE MODEL DEFINITIONS DATA STRUCTURES
12
ENTER DESIGN DATA FOR INSTANCES ALONG WITH CONNECTIVITY INFORMATION
13
RELATE DESIGN INSTANCES TO THE LIBRARY OF MODEL DEFINITIONS
14
ALTER AND CONNECT THE DESIGN INSTANCES IN SUCH A WAY AS TO ACHIEVE OPTIMUM CHARACTERISTICS OF SIZE, PATH DELAY POWER, ETC. ACCORDING TO A SET OF RULES
15
PREPARE CIRCUIT DESIGN IN A FORMAT FOR USE WITH AN AUTOMATED FABRICATION SYSTEM

BAD ORIGINAL

Neu eingereicht / Newly filed
Nouvellement déposé

FIG. 2.

21
ENTER ABSTRACT COMPONENT DATA FROM LIBRARY INTO MODEL DEFINITION DATA STRUCTURES
22
ENTER TARGET TECHNOLOGY COMPONENT DATA FROM LIBRARY INTO MODEL DEFINITION DATA STRUCTURES
23
ENTER DESIGN DATA WITH CONNECTED INSTANCES OF THE ABSTRACT COMPONENTS
24
SET UP POINTERS FOR PATH TRAVERSAL AND POINTERS TO ASSOCIATED RULES
25
TEST ASSOCIATED RULES AND WHEN 'TRUE', APPLY RULE RESULTS
26
REPEAT STEP 25 UNTIL CIRCUIT DESIGN IS STABILIZED
27
PREPARE CIRCUIT DESIGN IN FORMAT FOR USE WITH AN AUTOMATED FABRICATION SYSTEM

BAD ORIGINAL

Neu eingereicht / Nouvellement déposé

FIG. 3.
300
ALL RULE BASES TABLE
301
RULE BASE
RULE BASE
302
NAME
303
GENERAL RULE BASE ATTRIBUTES
304
RULE TABLE
305
306
RULE FILE
307
RULE FILE
(19)
RULE FILE
308
310
ALL DESIGNS TABLE
311
DESIGN
DESIGN
312
RULES OF DESIGN
313
(10)
MODEL DEFINITION TABLE
314
MODEL DEFINITION PRIMITIVE
315
MODEL DEFINITION
316
RULES OF MODEL DEFINITION
317
MODEL INSTANT LIST
318
319
MODEL INSTANCE
MODEL INSTANCE
320
321
RULES OF MODEL INSTANCE

BAD ORIGINAL

FIG. 4.

RULE
40
NAME
41
COMMENTS
*
42
ANTECEDENT
43
CONSEQUENCE
44
VERSION
45
HISTORY
46
SIZEWIN
47

COUNT-OF-INPUTS
QUALIFIED OBJECT
510
IS
VERB
511
N
PRIMITIVE OBJECT
512
COUNT-OF-INPUTS
QUALIFIED OBJECT
520
IS-SAME-AS
VERB
521
COUNT-OF-OUTPUTS
QUALIFIED OBJECT
522
ANY
ADJECTIVE
530
SIGNALS-OF-INPUTS
QUALIFIED OBJECT
531
ARE-NOT
VERB
532
PRESENT
PRIMITIVE OBJECT
533
NO
ADJECTIVE
540
SIGNALS-OF-INPUTS
QUALIFIED OBJECT
541
ARE-IN
VERB
542
SIGNAL-OF-OUTPUTS
QUALIFIED OBJECT
543
TAG {RESULT}
TAG-ID
550
IS-SUM-OF
PROCEDURE
551
COUNT-INPUTS
OBJECT
552
COUNT-OUTPUTS
OBJECT
553

FIG. 5.

610
COMMAND "REMOVE" "REMOVE-IF"
611
QUALIFIED OBJECT(S)
620
COMMAND "INSERT"
621
INSTANCE EQUATION FORM(S)
630
COMMAND "REPLACE"
631
QUALIFIED OBJECT(S)
632
"WITH"
633
INSTANCE EQUATION FORMS
640
COMMAND "SYNTHESIZE"
641
"FROM"
642
QUALIFIED OR PRIMITIVE OBJECT
643
"TO"
644
QUALIFIED OR PRIMITIVE OBJECT
645
COLLECTOR OF MACRO CHIPS
650
COMMAND "MODIFY"
651
QUALIFIED OBJECT
652
"WITH"
653
PRIMITIVE OBJECT
660
COMMAND "LISP"
660
LISP SOURCE CODE PROCEDURE

*FIG. 6.*

Neu eingereicht / Newly filed
Nouvellement déposé

701
SIGNAL
NAME "a<5:37"
702
SIGNAL
NAME "four"
703
MODEL INSTANCE
704
SIGNAL
NAME = "x (2:0)"
MSB = 2
LSB = Ø
705
RULE
RULE CONSEQUENCE
(SYNTHESIZE FROM MSB-IST-OUT TO LSB-IST-OUT
706
(MACRORULE "REPLICATE"
(INSERT OUTS(N) = (PART I INS(N)))
)
707
VALUE TABLE
INDEX
VALUE
"four"
4
708
RESULT OF RULE APPLICATION:
CURRENT BIT, n=2
710
a(5)
"tie hi"
711
MODEL INSTANCE
709
x (2)
712
2 1 0
4≡ 1 0 0
CURRENT BIT, n=1
714
a(4)
"tie lo"
715
MODEL INSTANCE
713
x (1)
716
CURRENT BIT, n=0
717
a(3)
"tie lo"
718
MODEL INSTANCE
716
x (0)
719

*FIG. 7.*

Neu eingereicht / Newly filed
Nouvellement déposé

A (5:3)
830
INST
831
B (10:8)
832
INST
833
C (2:∅)
834
RULE
MACRORULE
835
RULE
MACRORULE
836
RESULT:
A(5)
837
INST
838
B (10)
839
INST
840
C (2)
841
842
A (4)
843
INST
844
B (9)
845
INST
846
C (1)
847
A (3)
848
INST
849
B (8)
850
INST
851
C (∅)

FIG. 8.

FIG. 9.

DEF. EQL.
961
962
"a(2:0)"
960
MODEL INSTANCE OF EQL.
964
"a=b"
"b(2:0)"
963

RESULT:
965
"a(2)"
966
"b(2)"
XOR
967
968
AC% BD%
NOT
969
970
DD% TEMP%(2)
AND
971
972
"a=b"
973
"a(1)"
974
"b(1)"
XOR
975
976
AB% BC%
NOT
977
978
DD% TEMP%(1)
AND
979
980
DD% PROP%(1)
981
"a(0)"
"b(0)"
982
XOR
983
984
AA% BB%
NOT
985
DD% PROP%(ϕ)
986

FIG. 10.

MUX4x
a(2:0)
b(2:0)
c(7:5)
d(2:0)
e(6:5)
D0
D1
D2
D3
SEL
x(2:0)
msb=6
990
991
992
RULE CONSEQUENCE
(SYNTHESIZE FROM MSB-5TH-IN
TO MSB-5TH-IN
(MACRORULE))
993
MACRORULE CONSEQUENCE
(INSERT OUTS =
(MUX4x% IST-IN 2ND-IN 3RD-IN 4TH-IN
) 5TH-IN(N) 5TH-IN(N-1))
MUX4x%
995
x(2:0)
msb=2
lsb=0
e(6)
e(5)
SEL 2
SEL 1
994
996
RULE CONSEQUENCE
(SYNTHESIZE FROM MSB-IST-OUT
TO LSB-IST-OUT
(MACRORULE))
997
MACRORULE CONSEQUENCE
(INSERT OUTS(N) =
(MUX_PART IST-IN(N) 2ND-IN(N)
3RD-IN(N) 4TH-IN(N)
5TH-IN 6TH-IN)
a(2) b(2) c(7) d(2) e(6) e(5)
x(2)
998
a(1) b(1) c(6) d(1) e(6) e(5)
x(1)
999
a(0) b(0) c(5) d(0) e(6) e(5)
x(0)
900